# FASCICULE DE BREVET EUROPEEN

(11) **EP 0 362 583 B1**
(45) Date de publication et mention de la délivrance du brevet: **10.03.1993**
(21) Numéro de dépôt: 89116945.0
(22) Date de dépôt: 13.09.1989
(51) Int. Cl.: H03C 7/02, H04L 27/20

(54) **Modulateur hyperfréquence à deux états de phase: O, Pi à très faibles pertes**
Mikrowellen-Modulator für zwei Phasenzustände : O, Pi mit sehr niedrigen Verlusten
Microwave modulator for two phase states : O, Pi, with very small losses

(30) Priorité: 19.09.1988 FR 8812192
(43) Date de publication de la demande: 11.04.1990
(73) Titulaire: ALCATEL TELSPACE, 92734 Nanterre Cédex (FR); ALCATEL N.V., NL-1077 XX Amsterdam (NL)
(72) Inventeur: Martineau, Didier, F-78700 Conflans Sainte Honorine (FR)
(74) Mandataire: Weinmiller, Jürgen

(56) Documents cités:
- US-A- 4 301 432
- PATENT ABSTRACTS OF JAPAN, vol. 10, no. 255 (E-433)[2311], 2 septembre 1986; & JP-A-61 81 057 (TOSHIBA CORP.) 24-04-1986
- PATENT ABSTRACTS OF JAPAN, vol. 8, no. 53 (E-231)[1490], 9 mars 1984; & JP-A-58 206 265 (NIPPON DENKI K.K.) 01-12-1983
- F.E. Gardiol: "Introduction to Microwaves" C4.6, paragraphe 6.8.5, page 309, Sertech Hause, 1984

## Description

L'invention concerne un modulateur hyperfréquence à deux états de phase O,Pi (π) à très faibles pertes.

Une modulation cohérente est caractérisée par le fait que la fréquence de la porteuse est multiple de la fréquence de rythme du signal binaire à transmettre. Pour les débits numériques élevés, la cohérence est difficile à conserver et la modulation est de type non cohérent : les sauts de phase ont lieu à des instants où la phase de la porteuse a une valeur aléatoire φ équirépartie sur l'intervalle (0,2π). Si l'on représente le signal à transmettre par une succession de 0 et de 1 de durée T, dans une modulation avec codage direct à deux états de phase, on établit une correspondance entre la valeur 0 ou 1 de l'élément binaire et un état de phase choisi parmi deux : pour faciliter la reconnaissance à la démodulation, il est évident que l'éloignement entre les deux états doit être maximal : soit 0 et π.

L'objet de l'invention est de proposer un modulateur hyperfréquence à deux états de phases 0 et Pi (π) à très faibles pertes, comprenant entre une entrée (E) qui reçoit une porteuse pure à la fréquence fo et la sortie qui délivre une porteuse modulée à deux états de phase :
- un premier élément de commutation,
- et en parallèle sur celui-ci, un second élément de commutation en série avec une ligne principale,
- un système de commande permettant de faire conduire le premier élément ou le second, et de bloquer l'autre,

caractérisé en ce que cette ligne principale a une longueur L = λ o/2, λ o étant la longueur d'onde correspondant à la fréquence fo, et en ce que le circuit de commande comporte trois lignes de longueur λo/4 qui ont leurs premières extrémités reliées respectivement :
- pour la première ligne au point commun aux deux éléments de commutation,
- pour la seconde ligne à la seconde borne du premier élément de commutation,
- pour la troisième ligne à l'extrémité de la ligne principale non reliée au second élément de commutation, la première ligne ayant sa seconde extrémité reliée à la masse, les deux autres ayant leur seconde extrémité, qui reçoit respectivement un signal de commande, reliée à la masse à travers une capacité ; une capacité étant introduite entre la ligne principale et la seconde borne au premier élément de commutation.

Dans une réalisation particulière les éléments de commutation sont des diodes PIN.

Les caractéristiques et avantages de l'invention ressortiront d'ailleurs de la description qui va suivre, à titre d'exemple non limitatif, en référence aux figures annexées sur lesquelles :
- la figure 1 illustre un modulateur de l'art connu,
- les figures 2 et 3 illustrent le modulateur de l'invention.

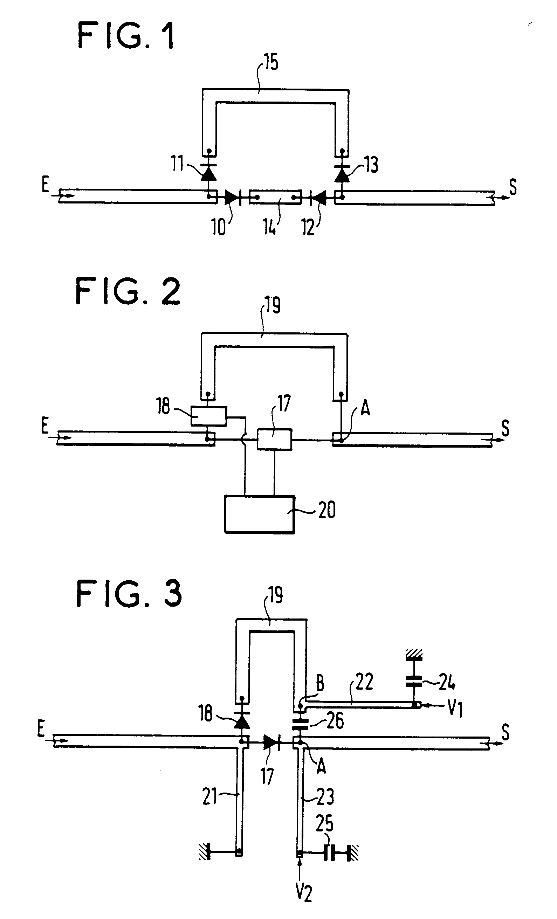

Le modulateur classique qui est connu du livre "Introduction to Microwaves", F.E. Gardiol, Paragraphe 6.8.5, page 309, tel que représenté sur la figure 1, comprend quatre diodes 10, 11, 12, 13, les deux premières 10, 11 ayant leurs anodes branchées à l'entrée E, et deux autres 12, 13 ayant leurs anodes branchées à la sortie S. Les diodes 10 et 12 sont reliées entre elles par une ligne 14 de longueur L, et les diodes 11 et 13 sont reliées entre elles par une ligne 15 de longueur L + λ o/2 ; λ o étant la longueur d'onde du signal d'entrée.

Dans ce modulateur, un système de commande, non représenté, permet de faire conduire soit les diodes 10 et 12, soit les diodes 11 et 13 : la différence des chemins parcourus par la porteuse, lorsque le signal est véhiculé par la ligne 14 ou lorsqu'il est véhiculé par la ligne 15, vaut donc λ o/2 ; ce qui correspond à un déphasage de la porteuse de π.

Le modulateur selon l'invention, tel que représenté à la figure 2, comprend, entre une entrée E qui reçoit une porteuse pure à la fréquence fo et la sortie S qui délivre une porteuse modulée à deux états de phase o - π, un premier élément de commutation 17 à très faibles pertes, par exemple une diode PIN, dont l'impédance varie en fonction du courant qui la traverse, et en parallèle sur celui-ci un second élément de commutation 18 à très faibles pertes en série avec une ligne principale 19 de longueur L = λo/2, λ o étant la longueur d'onde correspondant à la fréquence fo.

Un système de commande 20 permet de faire conduire le premier élément de commutation 17 ou le second 18, et de bloquer l'autre.

La longueur L de la ligne de transmission 19 étant égale à λo/2 à la fréquence fo, si cette ligne est chargée à l'une de ses extrémités par une impédance Ze, l'impédance mesurée à son autre extrémité vaut : Zs = Ze.
En fonctionnement :
- Lorsque l'élément 17 conduit et que l'élément 18 est bloqué, l'élément 18 présente une impédance infinie ; l'impédance ramenée au point A par la ligne 19 est donc infinie. La porteuse fo transite donc par l'élément 17, et la ligne 19 ne perturbe pas l'impédance au point A.
- Lorsque l'élément 18 conduit et que l'élément 17 est bloqué, l'élément 17 présente une impédance infinie. La porteuse fo transite par l'élément 18 et la ligne 19. Elle est déphasée π (longueur L = λo/2) par rapport au chemin parcouru lorsque l'élément 17 conduit.

Le modulateur, ainsi défini, est donc un modulateur à deux états de phases qui ne nécessite que deux éléments de commutation 17 et 18, par exemple deux diodes PIN, et non quatre comme dans la structure classique : ses pertes sont donc deux fois plus faibles que pour cette structure classique.

Dans un exemple de réalisation, tel que représenté sur la figure 3, les deux éléments de commutation 17 et 18 sont deux diodes PIN.

Entre l'extrémité de la ligne principale 19 non reliée à la diode 18 et le point A, est introduite une capacité 26, composant qui est transparent au signal hyperfréquence véhiculé.

Le système de commande 20 est composé de trois lignes 21, 23 et 22 de longueur λ o/4 qui ont leurs premières extrémités reliées respectivement :
- pour la première ligne 21, au point commun aux deux diodes 17 et 18,
- pour la seconde ligne 23 à la seconde électrode de la première diode 17,
- pour la troisième ligne 22 à l'extrémité de la ligne principale 19 non reliée à la seconde diode 18.

La première ligne 21 a sa seconde extrémité reliée à la masse, les deux autres 22 et 23 ont leur seconde extrémité, qui reçoit respectivement un signal de commutation V1 ou V2, reliée à la masse à travers une capacité 24 ou 25.

Ces différentes lignes en λ o/4 ramènent sur le circuit principal une impédance infinie qui ne perturbe pas le signal véhiculé. Ainsi aux points A et B, on ramène respectivement les tensions de commande V2 et V1.

Ces deux signaux V1 et V2 sont deux signaux en opposition de phase qui permettent de bloquer la diode 17 ou la diode 18 et de faire conduire l'autre. Ces signaux varient entre +V et -V, V étant une tension supérieure à l'amplitude du signal hyperfréquence véhiculé pour permettre ce blocage.

Pour une polarité différente des signaux V1 et V2, on peut inverser le sens des deux diodes 17 et 18.

Il est bien entendu que la présente invention n'a été décrite et représentée qu'à titre d'exemple préférentiel et que l'on pourra remplacer ses éléments constitutifs par des éléments équivalents sans, pour autant, sortir du cadre de l'invention.

## Revendications

1. Modulateur hyperfréquence à deux états de phase 0,Pi à très faibles pertes, comprenant entre une entrée (E) qui reçoit une porteuse pure a la fréquence fo et la sortie qui délivre une porteuse modulée à deux états de phase :
- un premier élément de commutation (17),
- et en parallèle sur celui-ci, un second élément de commutation (18) en série avec une ligne principale (19),
- un système de commande (20) permettant de faire conduire le premier élément (17) ou le second (18), et de bloquer l'autre,
caractérisé en ce que cette ligne principale a une longueur L = λo/2 λ o étant la longueur d'onde correspondant à la fréquence fo, et en ce que le circuit de commande (20) comporte trois lignes de longueur λ o/4 qui ont leurs premières extrémités reliées respectivement :
- pour la première ligne (21) au point commun aux deux éléments de commutation,
- pour la seconde ligne (23) à la seconde borne du premier élément de commutation (17),
- pour la troisième ligne (22) à l'extrémité de la ligne principale (19) non reliée au second élément de commutation (18), la première ligne (21) ayant sa seconde extrémité reliée à la masse, les deux autres (22, 23) ayant leur seconde extrémité, qui reçoit respectivement un signal de commande (V1 ou V2), reliée à la masse à travers une capacité (24, 25) ; une capacité (26) étant introduite entre la ligne principale (19) et la seconde borne au premier élément de commutation (17).

2. Modulateur selon la revendication 1, caractérisé en ce que les éléments de commutation (17, 18) sont des diodes PIN.

## Patentansprüche

1. Mikrowellenmodulator mit zwei Phasenzuständen 0 und π sowie sehr geringen Verlusten, wobei er zwischen einem Eingang (E), der einen reinen Träger der Frequenz fo zugeführt erhält, und einem Ausgang, der einen mit zwei Phasenzuständen modulierten Träger liefert, folgende Elemente enthält:
- ein erstes Schaltelement (17),
- und parallel hierzu ein zweites Schaltelement (18) in Reihe mit einer Hauptleitung (19),
- und ein Steuersystem (20), das es erlaubt, das erste (17) oder das zweite Schaltelement (18) durchzuschalten und das jeweils andere zu blockieren,
dadurch gekennzeichnet, daß die Hauptleitung eine Länge L = λo/2 besitzt, wobei λo die Wellenlänge entsprechend der Frequenz fo ist, und daß der Steuerkreis (20) drei Leitungen einer Länge λo/4 besitzt, deren erste Enden angeschlossen sind an:
- einen gemeinsamen Punkt der zwei Schaltelemente, was die erste Leitung (21) angeht,
- den zweiten Anschluß des ersten Schaltelements (17), was die zweite Leitung (23) angeht,
- das nicht an das zweite Schaltelement (18) angeschlossene Ende der Hauptleitung (19), was die dritte Leitung (22) angeht,
wobei das zweite Ende der ersten Leitung (21) an Masse liegt und die zweiten Enden der beiden anderen Leitungen (22, 23), die je ein Steuersignal (V1 oder V2) zugeführt erhalten, über je einen Kondensator (24, 25) an Masse liegen und wobei ein Kondensator (26) zwischen die Hauptleitung (19) und den zweiten Anschluß des ersten Schaltelements (17) eingefügt ist.

2. Modulator nach Anspruch 1, dadurch gekennzeichnet, daß die Schaltelemente (17, 18) PIN-Dioden sind.

## Claims

1. A very low loss microwave modulator having two phase states: 0, π; the modulator comprising the following between an input (E) which receives a pure carrier at a frequency f₀, and an output which delivers a carrier modulated with two phase states:
- a first switching element (17);
- in parallel therewith, a second switching element (18) connected in series with a main transmission line (19); and
- a control system (20) for causing a selected one of the first and second switching elements (17, 18) to be conductive and for causing the other one to be non-conductive;
the modulator being characterized in that said main transmission line is of length L = λ₀/2 where λ₀ is the wavelenght corresponding to the frequency f₀, and in that said control circuit (20) comprises three transmission lines of length λ₀/4 having their first ends respectively connected as follows:
- the first line (21) to the point common to the two switching elements;
- the second line (23) to the second terminal of the first switching element (17); and
- the third line (22) to that end of the main line (19) which is not connected to the second switching element (18);
the first line (21) having its second end connected to ground, and the other two lines (22, 23) having their second ends connected to receive respective control signals (V1 and V2) and connected to ground via respective capacitors (24, 25); and
a capacitor (26) being inserted between the main line (19) and the second terminal of the first switching element (17).

2. A modulator according to claim 1, characterized in that the switching elements (17, 18) are PIN diodes.
